# EUROPEAN PATENT APPLICATION

(11) **EP 2 587 898 A1**
(43) Date of publication of application: **01.05.2013**
(21) Application number: 11187045.7
(22) Date of filing: 28.10.2011
(51) Int. Cl.: H05K 1/02, H05K 3/00

(54) **Led printed circuit board with surface mounted spring**

(71) Applicant: Hella KGaA Hueck & Co., 59552 Lippstadt (DE)
(72) Inventor: Kerpe, Alexander, 59555 Lippstadt (DE)
(74) Representative: Lohr, Georg

(57) **Abstract**

A LED-based lighting component is disclosed. It comprises of a plurality of LEDs mounted to a printed circuit board. Furthermore, a plurality of surface mount springs of a metal sheet is glued and/or soldered to the printed circuit board. The printed circuit board is pressed towards a heat sink by asserting force to the springs. This allows stable and long lasting thermal connection between the LED and the heat sink.

## Description

### Field of the invention

The invention relates to a LED-based lighting component, a printed circuit board holding LEDs and to an assembly method of such a component.

### Description of the related art

LED lighting systems offer significant advantages over traditional incandescent, HID and fluorescent lamps. LEDs are of smaller size, offer higher reliability, longer operational life and lower energy consumption. However, there are specific requirements when using LEDs. As increased operating temperature significantly reduces lifetime, cooling is of high importance.

The US patent publication US 7,300,182 B2 a printed circuit board with LEDs soldered thereon. To improve cooling, the printed circuit board is fastened to a heat sink by screws. This offers a poor long-term stability as the material of the printed circuit board undergoes plastic deformation, which results in decreasing force with time between the printed circuit board and the heatsink.

### Summary of the invention

The problem to be solved by the invention is to provide means for cooling LEDs mounted to a printed circuit board. Furthermore, the thermal contact between a

LED and a heat sink should be reliably constant over a long time. Assembly of the unit should be efficient, reproducible and inexpensive.

Solutions of the problem are described in the independent claims. The dependent claims relate to further improvements of the invention.

A preferred embodiment relates to a LED-based lighting component comprising a printed circuit board and at least one LED mounted thereon. Another embodiment relates to a printed circuit board and at least one LED mounted thereon. Preferably, the LED is a surface mounted component. Furthermore at least one spring is mounted to the surface of the printed circuit board. Preferably, the spring is a surface mount component. This means, it is a component to which the surface mount technology is applicable, which may be mounted on at least one soldering pad at the printed circuit board or glued to the surface of the printed circuit board. Usually surface mount components do not require holes or are otherwise penetrating the printed circuit board. Anyway, there may be specific embodiments of the surface mounted spring, which has at least one post to be held within at least one hole of the printed circuit board. Preferably, the surface mount spring is of sheet metal with a punched or cut out protrusion. This allows for a precise and inexpensive manufacturing process of high volumes of the surface mount spring. This spring is a form such that it does not assert unnecessary forces to the soldiering connection between the spring and the printed circuit board. Accordingly, is preferred, if the force to the spring comes under a right angle to the printed circuit board. It is further preferred, if the springs are close to the regions with high thermal dissipation of the printed circuit board and/or components thereon and away from regions with high voltage or high-frequency signals.

Most preferably the surface mount spring is placed to the printed circuit board by a SMD pick and place machine. Preferably, this is done in the same process as placing the LEDs and other electronic components to the printed circuit board, thus reducing tolerances and assembly time.

In a further embodiment, a heatsink may be provided. The heatsink may further act as a mechanical support or an insulator. The heatsink may interact with the at least one spring for pressing the printed circuit board to the heatsink and therefore improving heat transfer. There may be further means for pressing the printed circuit board by at least one of the springs to a heatsink.

Furthermore, the printed circuit board may be inserted into a frame. For this purpose, the frame may have one or two braces. The frame is preferably made of metal or ceramics, most preferably of aluminum. Preferably, the frame is a profile, which may be manufactured by strand casting or pultrusion or extrusion. It preferably has overhangs to hold the surface mount reflector down by at least one spring to the printed circuit board and further to fix the reflector and the printed circuit board within the frame. The at least one spring asserts a predetermined force to the printed circuit board. This may further press the printed circuit board to the frame, further improving heat transfer to the frame. For easy assembly, the printed circuit board is pushed into an opening at the end of the profile. Furthermore it is preferred, if the springs have the form such that they can easily be inserted into the profile without getting stuck therein. Slipping of the printed circuit board within the profile my may be prevented by end caps or by a lug or a screw.

Mounting the printed circuit board within the frame is a very simple procedure. The first step the at least one spring is positioned on or preferably fixed and most preferably soldered to the printed circuit board. In the next step, the printed circuit board is inserted into the frame by pushing it into a slot opening at one end of the frame.

According to further embodiment, the printed circuit board is held by a holder to the heatsink. According to another embodiment, the printed circuit board is held between two parts of a housing. Here it is preferred, if one part is a good thermal conductivity and is thermally connected to the printed circuit board, while the other part has openings for exit of light and may contain further light guiding components.

By using at least one surface mounted spring on a printed circuit board it is possible to build LED lighting components which are comparatively simple and have a low number of components.

This embodiment results in a defined pressure of the printed circuit board (PCB) to the frame without any additional elements (e.g. screws, glue...). Due to the permanent elastic deformation of the flat spring, the thermal resistance between the PCB and the frame will not change over lifetime.

Another embodiment of the invention relates to a surface mounted spring. The spring has a frame 52, which is placed on the printed circuit board and preferably soldered or at least glued thereon. Extending from the frame is a lever 53, which can be pressed towards the frame by asserting a force to it. Preferably, this spring is made of sheet metal, most preferably by punching or laser cutting.

A method according to the invention comprises at least the steps of placing at least one LED on a printed circuit board and placing at least a surface mount spring to the same printed circuit board in the proximity of the at least one LED. The sequence of these steps can be reversed. Both steps are preferably done within the same manufacturing process. It is preferred, if both steps are done by pick and place machines. Therefore, no manual handling of the components is necessary. Consequently, a very high precision of placement and very low mechanical tolerances specifically of the relative positions of the at least one LED and the at least one surface mount spring can be achieved. Furthermore automatic handling prevents damaging or at least maladjustment of the at least one surface mount reflector. Most preferably, precision can be further increased by doing both steps with the same pick and place machine. After placing the at least one LED and the at least one surface mount spring to the printed circuit board, it may be heated by a reflow oven and/or a solder wave to solder the at least one LED and the at least one surface mount reflector to the printed circuit board.

### Description of Drawings

In the following, the invention will be described by way of example, without limitation of the general inventive concept, on examples of embodiment with reference to the drawings.
Figure 1 shows a preferred embodiment of the invention.
Figure 2 shows the preferred embodiment in a side view.
Figure 3 shows an embodiment in a sectional view.
Figure 4 shows a first spring in detail.
Figure 5 shows a second spring in detail.

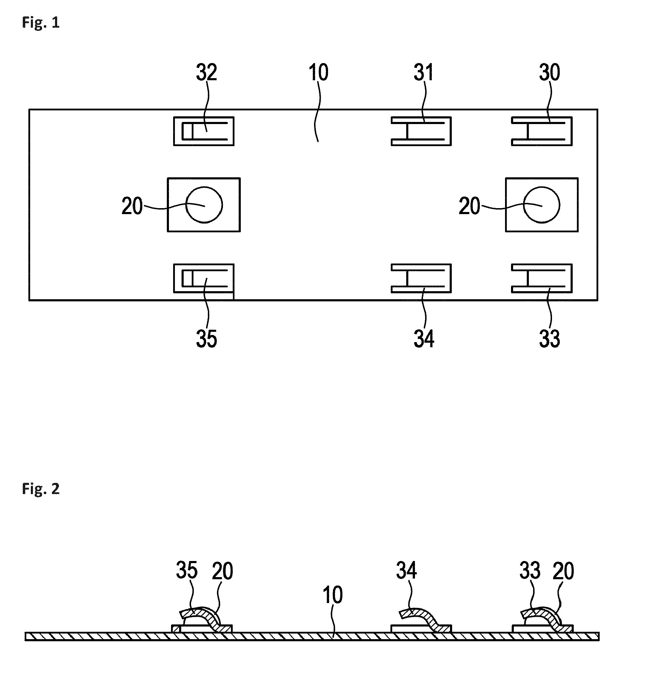

In figure 1, a preferred embodiment according to the invention is shown. A LED 20 is mounted to a printed circuit board 10. Furthermore, surface mount springs 30, 31, 32, 33, 34, 35 are located on the printed circuit board. These surface mount springs pads may be glued and/or soldered to the printed circuit board. The surface mount springs may be placed at the printed circuit board by a pick and place machine. In general, there may be any number of LEDs and of surface mount springs as well as other components on the printed circuit board. It is preferred, if the springs are mounted close to a LED allowing a good mechanical and thermal contact of the printed circuit board in the vicinity of the LED with a heat sink under the printed circuit board. There are two types of slightly different springs. The first type of spring 30, 31, 33, 34 with open ends is smaller, while the second type of spring 32, 35 requires little more space but offers a better distribution of force on the printed circuit board.

Figure 2 shows the preferred embodiment in a side view. Here the surface mount springs 23, 34, 45 are shown from their sides in front of LEDs 20.

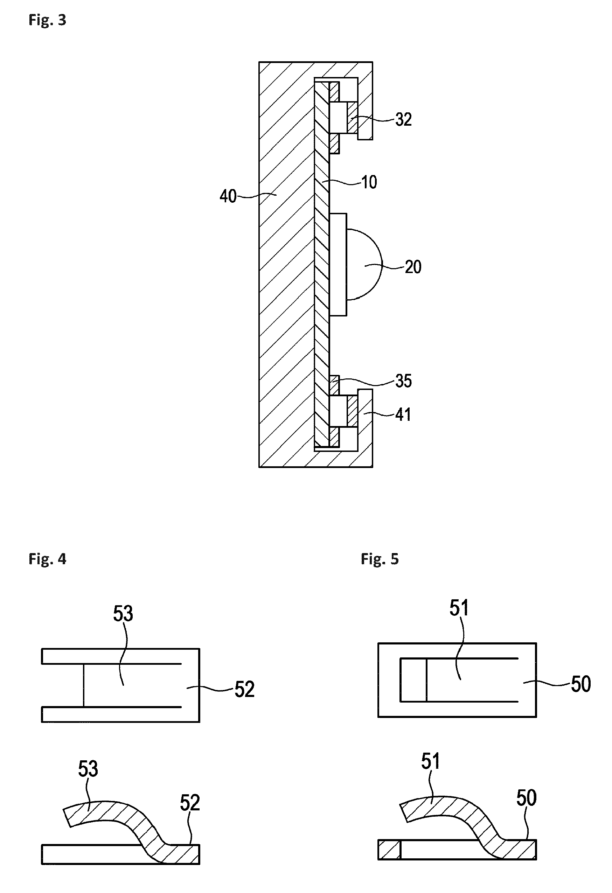

In figure 3, a sectional view of the printed circuit board mounted within a frame is shown. The printed circuit board 10 is assembled with a frame 40. The frame has at least one overhang 41, preferably two overhangs, to hold the printed circuit board 10 together by surface mount springs 32, 35 within the frame. The at least one overhang 41 preferably interacts with the at least one surface mount spring 32, 35 to assert a predetermined force to the surface mount reflector. These springs must be dimensioned such that they can at least compensate variations in thickness of the printed circuit board caused by manufacturing and during time as well as variations of the gap under the overhangs. Frame 40 may be designed to act as a mechanical support structure and/or a heat sink and/or electrical insulator for the assembly. Instead of the frame there may be a heat sink attached to the printed circuit board.

In figure 4, a first type of springs is shown in detail. The spring has a body or frame 52, which is placed on the printed circuit board and preferably soldered or at least glued thereon. Extending from the body frame is a lever 53, which can be pressed towards the body or frame by asserting a force to it in a direction approximately from top to bottom in the orientation as shown in this figure. The frame and the lever are of one piece.

In figure 5, a second type of springs is shown. The spring has a body or frame surrounding the spring offering a better distribution of force over the first type of springs.

### List of reference numerals

- 10: printed circuit board
- 20: LED
- 30, 31, 33, 34: first type of springs
- 32, 35: second type of springs
- 40: frame/heat sink
- 41: overhang
- 50: second type spring body
- 51: second type spring lever
- 52: first type spring body
- 53: first type spring lever

## Claims

1. LED-based lighting component comprising at least:
- at least one LED (20) mounted to a printed circuit board (10)
- at least one surface mount spring (30, 31, 32, 33, 34, 35) located on the printed circuit board.

2. LED-based lighting component according to claim 1,
**characterized in, that**
the at least one surface mount spring (30, 31, 32, 33, 34, 35) is made of a metal sheet.

3. LED-based lighting component according to any one of the preceding claims,
**characterized in, that**
the printed circuit board is pressed to a heat sink (40) by asserting force to at least one surface mount spring (30, 31, 32, 33, 34, 35).

4. LED-based lighting component according to any one of the preceding claims,
**characterized in, that**
the at least one surface mount spring (30, 31, 32, 33, 34, 35) is arranged close to the at least one LED.

5. LED-based lighting component according to any one of the preceding claims,
**characterized in, that**
the component comprises a frame (40) for holding the printed circuit board (10).

6. LED-based lighting component according to claim 5,
**characterized in, that**
the at least one surface mount spring (30, 31, 32, 33, 34, 35) interacts with the frame (40) to hold the printed circuit board down to a heat sink (40).

7. Surface mount spring for mounting on the printed circuit board by surface mounting technologies,
**characterized in**, by
at least one frame (50, 52) which can be glued and/or soldered to a printed circuit board and a lever (51, 53) extending thereof.

8. Surface mount spring according to claim 7,
**characterized in, that**
the surface mount spring (30, 31, 32, 33, 34, 35) is made of a metal sheet.

9. Surface mount spring according to claim 8,
**characterized in, that**
the surface mount spring (30, 31, 32, 33, 34, 35) is made by punching and/or laser cutting.
